(19) Europäisches Patentamt
European Patent Office
Office européen des brevets

(11) EP 2 423 951 B1

(12) **EUROPEAN PATENT SPECIFICATION**

(45) Date of publication and mention
of the grant of the patent:
**20.07.2016 Bulletin 2016/29**

(51) Int Cl.:
***H01L 21/20*** *(2006.01)*

(21) Application number: **11176589.7**

(22) Date of filing: **04.08.2011**

(54) **Antiphase domain boundary-free III-V compound semiconductor material on semiconductor substrate and method for manufacturing thereof**

Begrenzungsfreies Antiphasendomänen-III-V-Verbindungshalbleitermaterial auf einem Halbleitersubstrat und Herstellungsverfahren dafür

Matériau semi-conducteur de composé III-V sans limites de domaine antiphase sur un substrat semi-conducteur et son procédé de fabrication

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **05.08.2010 US 371008 P**

(43) Date of publication of application:
**29.02.2012 Bulletin 2012/09**

(73) Proprietors:
• **IMEC**
**3001 Leuven (BE)**
• **Katholieke Universiteit Leuven, K.U. Leuven R&D**
**3000 Leuven (BE)**

(72) Inventors:
• **Wang, Gang**
**St. Peters, MO Missouri 63376 (US)**
• **Caymax, Matty**
**3000 Leuven (BE)**
• **Leys, Maarten**
**5642 NT Eindhoven (NL)**
• **Wang, Wei-E**
**3090 Overijse (BE)**
• **Waldron, Niamh**
**3000 Leuven (BE)**

(74) Representative: **Sarlet, Steven Renaat Irène et al Gevers**
**Intellectual Property House**
**Holidaystraat 5**
**1831 Diegem (BE)**

(56) References cited:
**US-B1- 6 831 350**

• **GANG WANG ET AL: "Selective Epitaxial Growth of InP in STI Trenches on Off-Axis Si (001) Substrates", ECS TRANSACTIONS, ELECTROCHEMICAL SOCIETY, US, vol. 27, no. 1, 18 March 2010 (2010-03-18) , - 19 March 2010 (2010-03-19), pages 959-964, XP009155831, ISSN: 1938-5862, DOI: 10.1149/1.3360736**
• **G. WANG ET AL: "Selective Area Growth of InP in Shallow-Trench-Isolated Structures on Off-Axis Si(001) Substrates", JOURNAL OF THE ELECTROCHEMICAL SOCIETY, vol. 157, no. 11, 21 September 2010 (2010-09-21), page H1023, XP55017882, ISSN: 0013-4651, DOI: 10.1149/1.3489355**
• **PARK JI-SOO ET AL: "Facet formation and lateral overgrowth of selective Ge epitaxy on SiO2-patterned Si(001) substrates", JOURNAL OF VACUUM SCIENCE AND TECHNOLOGY: PART B, AVS / AIP, MELVILLE, NEW YORK, NY, US, vol. 26, no. 1, 4 January 2008 (2008-01-04), pages 117-121, XP012114057, ISSN: 1071-1023, DOI: 10.1116/1.2825165**
• **GUANG-PING TANG ET AL: "Antiphase-domain-free InP on (100) Si", JAPANESE JOURNAL OF APPLIED PHYSICS, PART 2 (LETTERS) JAPAN, vol. 31, no. 8A, 1 August 1992 (1992-08-01), pages L1126-L1128, ISSN: 0021-4922**

EP 2 423 951 B1

**Description**

**TECHNICAL FIELD**

The present invention relates to an engineered substrate comprising a III-V compound semiconductor material thereon and a method for manufacturing such a III-V compound semiconductor material on a semiconductor substrate.

**BACKGROUND ART**

Development of high performance III-V complementary metal oxide semiconductor (CMOS) devices, a type of CMOS utilizing high mobility III-V materials (such as GaAs or InGaAs) as channel instead of silicon, has been suffering from the difficulties of growing epitaxially defect-free III-V materials on the silicon substrate.

First, there is a large lattice-mismatch between the lattice constants of III-V materials and Si. Another difficulty in growing epitaxially III-V materials is the formation of anti-phase domain boundaries (APB) which are actually defects that act as deep level nonradiative recombination centers and consequently deteriorate the electrical performance of the device significantly.

To avoid APB, Si (001) or Ge (001) substrates with a miscut angle larger than 2 degrees are employed, the widely used miscut angle being 6 degrees. However, using miscut substrates induces additional problems in the epitaxial growth of the III-V compound materials on patterned wafers, such as surface morphology and crystal quality dependence on orientation (non-isotropy), resulting in a significant barrier for their acceptance in CMOS device fabrication. In addition, the actual impact of the miscut on carrier transport is not clear.

Yet another drawback is that miscut Si (001) substrates are not standard in Si CMOS industry. Consequently, it is of great interest to grow APB free III-V materials on the largely used (001) oriented Si substrates.

**SUMMARY OF THE INVENTION**

It is an aim of the present invention to provide a method of manufacturing of an engineered substrate comprising APB free III-V compound semiconductor.

This aim is achieved with the method of the first independent claim.

It is a further aim of the present invention to provide an antiphase domain boundaries (APB) free III-V compound semiconductor grown on a semiconductor substrate.

This further aim is achieved with the engineered semiconductor substrate of the second independent claim.

The method for manufacturing a III-V compound semiconductor material according to the invention comprises the steps of claim 1.

On double stepped surfaces of group IV semiconductor materials all the terraces have the same orientation, which make them highly suitable as a starting surface for growing APBs free III-V compound materials. The inventors have found that double stepped surface formation in the buffer layer upon thermal treatment can be promoted in a controlled manner locally, by growing the buffer layer having a predetermined thickness and comprising a group IV semiconductor material in a recessed region in the insulating layer of predetermined width, which exposes at least partially the substrate.

According to the invention, the predetermined width of the recessed region and the predetermined thickness of the buffer layer are chosen such that the buffer layer, after the thermal treatment, takes a rounded shape having a double stepped surface of which the step density multiplied by the step height is higher or equal to 0.05 everywhere on the buffer layer surface. It has been found that if the step density multiplied by the step height is higher or equal to 0.05 everywhere on the buffer layer surface, double step formation is energetically favoured. In order to promote the double step formation the temperature of the thermal treatment has to be higher than or equal to the roughening temperature of the buffer layer material. At this temperature, the free energy of step formation becomes zero and there is in other words no energy barrier to prevent double step formation.

According to the invention, the buffer layer is grown on the substrate made of a semiconductor material having a {001} orientation. The {001} orientation refers to the family of equivalent planes ((001), (100) etc.) and it is an exact orientation, such as widely used in high-volume silicon manufacturing. No miscut or off-cut of the substrate is required for the method of the invention. This is a very important advantage with respect to the state of the art substrates which make use of slight misorientations to prevent forming anti-phase boundary (APB) domains in the III-V grown material. Substrates made of a semiconductor material having a {001} orientation are standard in the CMOS industry and are therefore highly desirable as a substrate for growing III-V compounds.

In embodiments of the invention, the substrate can be made of silicon with an exact {001} orientation and the insulating layer can be silicon oxide. Advantageously, a plurality of recessed regions can be formed in a shallow trench isolation (STI) pattern which typically defines active areas in silicon separated by isolation areas made of silicon oxide.

In this way, the recessed regions are defined such that the sidewalls are in silicon oxide, while the bottom is exposing the silicon (001) substrate. In this approach some of the recessed regions on the wafer (substrate) can be filled up with a III-V compound material according to the method of the invention, while other recessed regions on the same wafer can be filled up with crystalline germanium, thereby achieving active areas in two different materials and enabling in this way the heterogeneous integration of e.g. advanced CMOS devices.

## BRIEF DESCRIPTION OF THE DRAWINGS

All drawings are intended to illustrate some aspects and embodiments of the present invention. The drawings described are only schematic and are non-limiting.

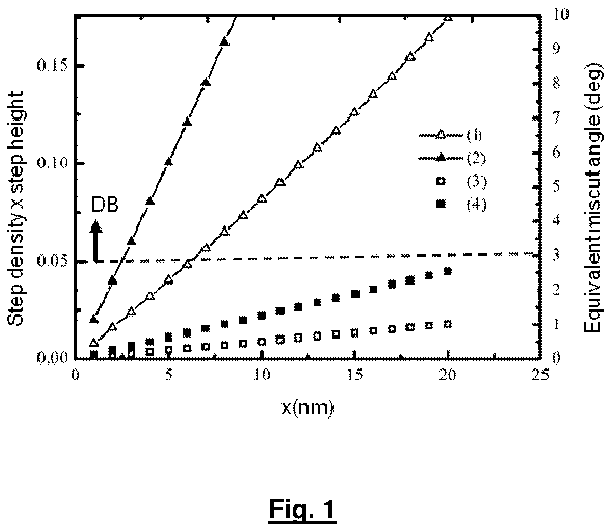

Figure 1 represents the step density x step height (left) and the equivalent miscut angle (right) as a function of the distance from the center of the trench, x for different combination of trench width (w) and buffer layer thickness (h): (1) w=100 nm, h=20 nm; (2) w=100 nm, h=50 nm; (3) w=300 nm, h=20 nm; (4) w=300 nm, h=50 nm. The horizontal dashed line at 0.05 indicates the lowest border of the double stepped surfaces domain (DB).

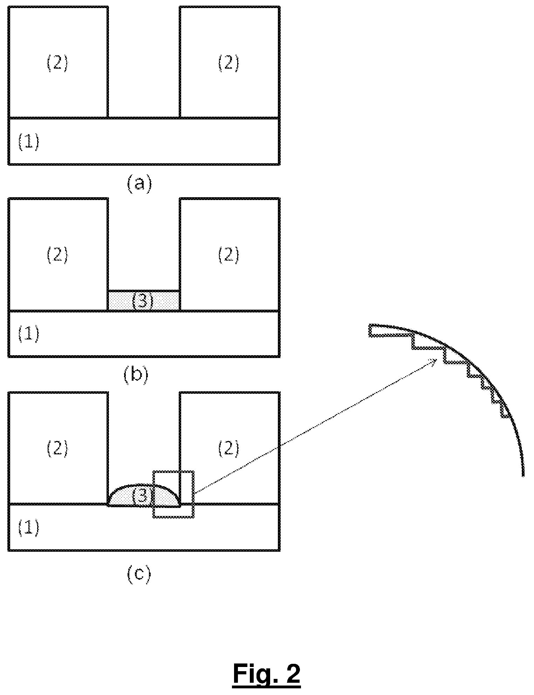

Figure 2 represents schematically a comparative example of the method of the invention, according to one embodiment, comprising: (a) trench formation in insulating material (2) exposing semiconductor substrate (1) with (001) or equivalent orientation; (b) epitaxial growth of a buffer layer (3) made of a group IV semiconductor material; (c) thermal treatment to form the double stepped surface of the a group IV semiconductor material shown in the insert.

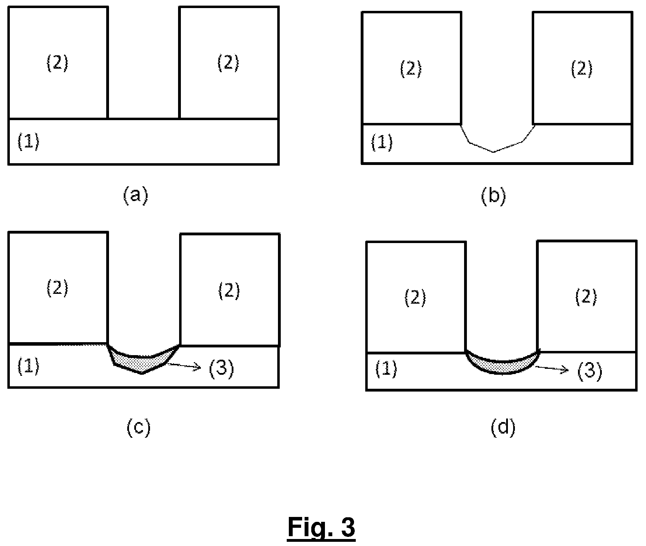

Figure 3 represents schematically the method of the invention, according to an embodiment, comprising: (a) trench formation in insulating material (2) exposing semiconductor substrate (1) with (001) or equivalent orientation; (b) isotropic etch of the substrate exposed in the trenches; (c) epitaxial growth of a buffer layer (3) made of a group IV semiconductor material; (d) thermal treatment to form the double stepped surface of the a group IV semiconductor material.

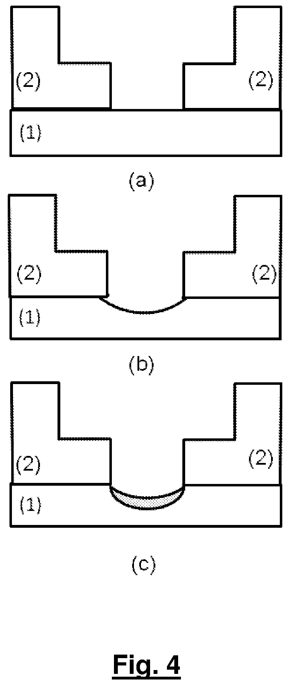

Figure 4 represents schematically the method of the invention, according to another embodiment, comprising: (a) dual damascene structure formation in insulating material (2) exposing semiconductor substrate (1) with (001) or equivalent orientation; (b) isotropic etch of the substrate exposed at the bottom of the dual damascene structure; (c) epitaxial growth of a buffer layer (3) made of a group IV semiconductor material; (c) thermal treatment to form the double stepped surface of the a group IV semiconductor material.

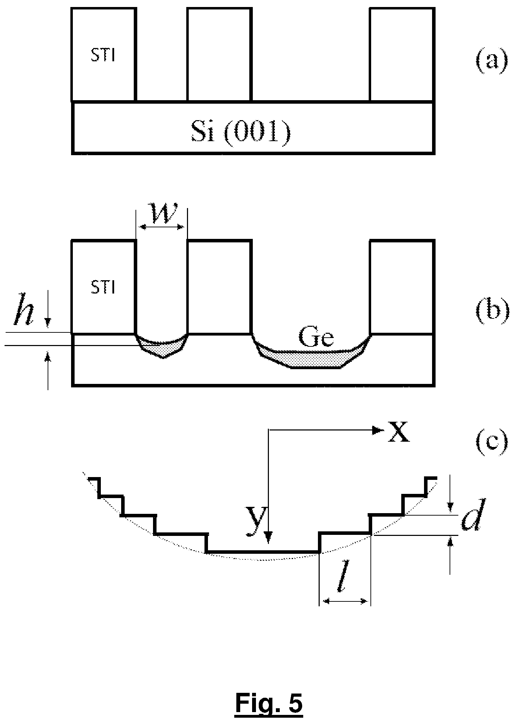

Figure 5 represents schematically the method of the invention, according to another embodiment, comprising: (a) STI trenches are defined on a Si (001) substrate: narrow (submicron) trench (left) and wide trench (right); (b) exposed Si substrate is over recessed such that a concave surface is obtained and thereupon a thin Ge layer is deposited; (c) the zoom-in view of the atomic steps on the Ge surface at the center of a submicron trench. A difference in step density at the center of the trench (x =0) and in the immediate proximity of the center of the trench can be observed between the narrow trench and the wide trench. The parameters associated with the atomic steps are shown, trench width w, atomic step height, d, terrace width, 1, and the maximum distance from the Ge surface to the reference Si surface, h.

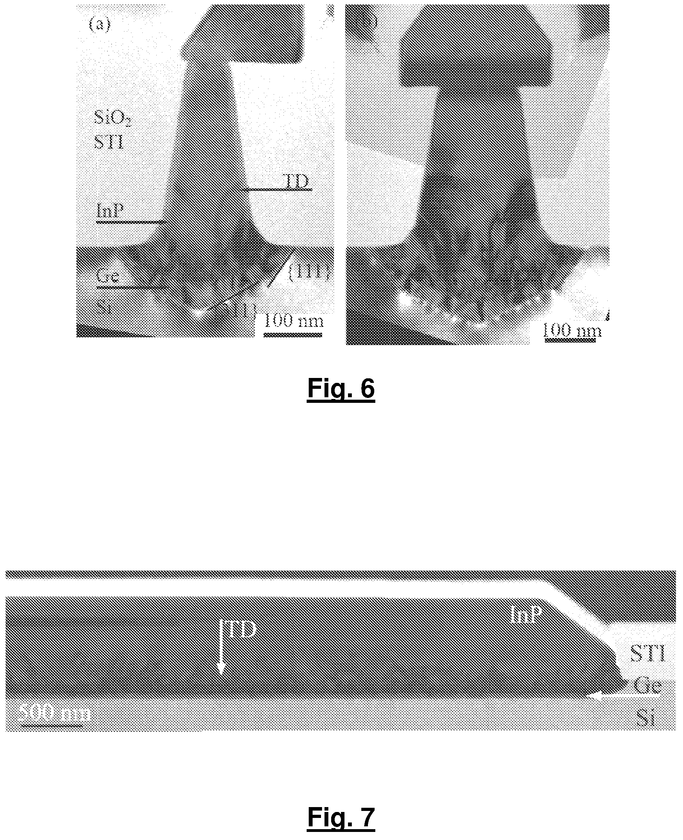

Figure 6 represents cross-section TEM images of InP layer grown in the 100 nm (a) and 200 nm (b) wide STI trenches. {111} and {311} Si facets were obtained after Si recess with HCl vapor phase etching. Threading dislocations (TDs) are confined in the bottom of the trenches.

Figure 7 represents a cross-section TEM image taken along the 200 nm trench in Fig. 6b

## DETAILED DESCRIPTION OF ILLUSTRATIVE EMBODIMENTS

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the invention.

Furthermore, the terms first, second, third and the like in the description and in the claims, are used for distinguishing between similar elements and not necessarily for describing a sequential or chronological order. The terms are interchangeable under appropriate circumstances and the embodiments of the invention can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the invention described herein can operate in other orientations than described or illustrated herein.

The term "comprising", used in the claims, should not be interpreted as being restricted to the means listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

There are several ways to tackle the lattice mismatch issues. One of the common methods is to use high aspect ratio structures in which defects are trapped at the bottom of the trench if the aspect ratio is sufficiently high. However, this method is still inadequate to completely remove the defects originated from the large mismatch.

Another method is to use lateral growth technique which involves restricting the defects originated from the bottom of a small trench and then grow defect-free III-V compound material in a lateral manner which avoids the mismatch issue. However, this method renders a forbidden area on top of the trench for device to be formed because this area (region) it is not defect-free. In addition, lateral growth technique is generally applied only to Si (111) wafers since direct growth of III-V compound on Si(001) is rather difficult.

One approach to integrate III-V compound materials on Si substrates is selective epitaxial growth in structures with shallow trench isolation (STI) pattern. A typical example of a STI pattern is described in detail elsewhere in the description Due to the aspect ratio trapping effect (also known as necking effect) in submicron trenches some of the defects can be trapped and get annihilated.

Selective epitaxial growth makes possible to fabricate Ge channel pMOS in the vicinity of III-V channel nMOS devices so that high performance CMOS devices can be fabricated on a single Si substrate. In addition, the integration of optoelectronic devices on a Si chip will also likely need selective epitaxial growth of III-V materials on the dedicated Si areas.

To avoid the formation of anti-phase domain boundaries in epitaxially grown III-V compound materials on un-patterned (blanket) substrates miscut substrates (wafers) were introduced.

A miscut or an off-cut substrate is a substrate having a surface crystal orientation which is deliberately miscut a few degrees off the main axis. The inclination is called miscut angle and the surface of such a miscut substrate is known as vicinal crystal surface. A vicinal crystal surface is thus one that is slightly misoriented with respect to a low-index direction, typically consist or terraces of the low index direction and steps that accommodate the misorientation.

The miscut Si wafers are not standard for high-volume wafer manufacturing, and they put additional problems to the growth of the III-V compound materials. For example, during the epitaxial growth of the III-V compound materials on patterned miscut Si wafers, a preferential growth with respect to the pattern orientation (e.g. trench direction) is developed. This non-isotropic behavior creates undesirable macrostep defects which affect further the performance of the devices.

The surface misorientation of a vicinal surface can be accommodated by single layers (SL) and double layers (DL) steps, leading to surfaces that are not only different in the height of the steps and the width of the terraces, but also in their basic lattice structure. However, a terrace width of a certain type of steps has the same value over the whole miscut substrate.

The single stepped surface of vicinal Si (100) has a two-sublattice structure with terraces of both 2x1 and 1x2 periodicity, which makes it unsuitable as a starting surface for growing APBs free III-V compound materials. On the other hand on the double layer stepped surface all the terraces have the same orientation which makes it highly suitable as starting surface for growing APBs free III-V compound materials. The terraces of a vicinal surface having only double layer steps would have the same width and height over the whole substrate. There are two types of single layer steps (SA and SB) and two types of double layers steps (DA and DB). Transitions from single layer steps to double layers steps (more specifically DB) are possible under certain annealing.

According to the invention, it has been found that surface double (B) steps formation can be promoted in a controlled manner locally, e.g. in a recessed region of a patterned substrate having a {001} exact orientation by growing first a thin buffer layer comprising, or entirely made of, a group IV semiconductor material, e.g. Ge, followed by a high temperature treatment. Upon applying the thermal treatment the thin buffer layer in the recessed region takes a curved shape as a result of surface energy minimization. The curved surface has a high density of surface steps, depending on the local surface curvature, single steps, single-double mixed steps, and double steps occur.

We found out that double steps formation is energetically favored when the product between the step density and step height at any point of the rounded surface is larger than 0.05. This value of the step density x step height corresponds to a surface inclination/misorientation of about 3 degree. Throughout the description this local inclination is also referred to as equivalent miscut angle.

The step density is defined as the number of steps per unit length. Upon the thermal treatment double steps are formed over the whole curved surface. The double steps at the center of the trench will have a different terrace width than the double steps in the vicinity of the trench walls. The step height of a double step equals the half of the lattice constant ($a/2$) for materials with diamond structure like Si and Ge. This is valid also for the alloys of group IV semiconductor materials.

In particular the step height of the double stepped surface for Ge is about 0.283 nm (lattice constant of Ge is about 0.566nm) while for Si is 0.271 nm (lattice constant Si is about 0.543 nm). Given the fact that the step height of the double stepped surfaces is a constant for a given material, the constraint above regarding forming the double stepped surfaces can be translated for a given material to a step density constraint. For example, for gemanium a step density of about 1/(5nm) or 0.2 nm$^{-1}$ is required to form the double stepped surfaces.

In other words, the single steps are thermodynamically unstable and can be converted into double steps if the terrace width at the trench center is smaller or equal to 5 nm. Lower values of the terrace width, such as values between 2 and 5 nm can be beneficial as starting surface for III-V compound material growth. Variations are possible depending on the III-V compound material to be grown and an optimal value can be determined without undue burden by the skilled in the art.

The buffer layer curvature can be controlled by modifying the buffer layer thickness and/or the trench (recess) width.

As shown in Figure 1, for a given buffer layer thickness, e.g. 20 nm, only the 100 nm (curve 1) trench falls into the double step region (DB) at the (proximity of) trench center (x lower than about 5nm). The double step region in Figure 1 is the domain above the horizontal dotted line, corresponding to equivalent misorientations of at least 3 degree and a (step density x step height) value of 0.05 or higher.

For a thicker buffer layer (e.g. 50 nm) grown in a 100nm wide trench (curve 2) a distance very close to the trench center (x about 3nm) falls already in the double step region.

As shown in Figure 1 wider trenches (curves 3 and 4, w= 300 nm) leave the proximity of the trench center in the single step region, meaning that there is a higher risk for APB formation during III-V growth in these wide trenches. A thicker grown layer should be used to promote the double step formation in these wide trenches.

In an embodiment, the buffer layer with a double stepped surface can be formed by:

(i). growing epitaxially the buffer layer comprising the group IV semiconductor material on the exposed substrate and thereafter,
(ii). applying the thermal treatment thereby forming the double stepped surface of the buffer layer.

The temperature of the thermal treatment is higher or equal with a roughening temperature of the group IV semiconductor material of which the buffer layer is made. For example in case of germanium the temperature is higher than 600°C, preferably higher than 650°C, more preferably higher than 700°C. The upper limit in case of germanium is about 800°C. When choosing the anneal temperature, a certain variation of the roughening temperature with the layer thickness has to be taken into consideration, since the roughening temperature might slightly increase with the decreasing layer thickness.

A surface becomes rough, i.e., undergoes a roughening transition, at the temperature at which steps form spontaneously. At this temperature, called herein roughening temperature, the free energy of step formation becomes zero.

A comparative example of the invention includes further choosing a thickness of the buffer layer and a width of the recessed region such that upon applying the thermal treatment the buffer layer takes a convex shape having a double stepped surface with a (step density x step height) higher or equal to 0.05 everywhere on the surface. With 'everywhere on the surface' is meant that a (step density x step height) of at least 0.05 is achieved in the center of the trench and the proximity thereof. This minimum value corresponds to a local surface inclination of about 3 degree. This example is illustrated schematically in Figure 2 (a)-(c).

As used herein, "convex" is used according to the following definition, namely that a convex shape can be represented by a function that has a decreasing slope. "Decreasing" here means "non-increasing", rather than "strictly decreasing", and thus allows zero slopes.

In an embodiment of the invention the method comprises: performing an isotropic etch of the exposed substrate in the recessed region, prior to forming the buffer layer, such that the exposed substrate takes a concave shape. Thereupon a buffer layer is formed (grown) having also a concave shape. Upon applying the thermal treatment a double stepped surface is formed having a (step density x step height) value higher or equal to 0.05 everywhere on the surface. With 'everywhere on the surface' is meant that a (step density x step height) value of at least 0.05 is achieved in the center of the trench and the proximity thereof. This embodiment is illustrated schematically in Figure 3 (a)-(d).

As used herein, "concave" is used according to the following definition, namely that a concave shape is the mirror image of a convex shape and can be represented by a function having an increasing slope. Analogue with above, the interpretation of "increasing" includes zero slopes.

In the invention, the isotropic etch is performed by a wet etch process. In embodiments wherein the substrate is made of silicon, a KOH etch solution can be used to etch isotropic the substrate thereby forming the concave shape.

In different embodiments, an additional thermal treatment can be performed after the isotropic etch of the substrate and prior to forming the buffer layer. Preferably this additional thermal treatment can be applied in-situ in the epi reactor where the group IV buffer layer is grown, thereby removing any native oxide and/or contaminants present on the substrate surface.

In different embodiments of the invention, the recessed region can have a dual damascene profile. A dual damascene profile is schematically represented in Figure 4 (a) and is known in the art as a profile of a recessed region comprising a via or a hole exposing the substrate at the bottom and thereupon a trench, preferably wider than the via underneath. Growing the III-V compound semiconductor material in a dual damascene recessed profile has the additional benefit of forming a large area of high quality (APB-free) III-V compound semiconductor material both in the center of the recessed region (above the vias) and in the lateral trench that can be used as active area for III-V- based devices.

In different embodiments of the invention, the first semiconductor material is a group IV semiconductor such as silicon or germanium or combinations (alloys) thereof.

In embodiments of the invention the substrate can be made of silicon with an exact {001} orientation.

Further, in embodiments of the invention the insulating layer can be silicon oxide. Advantageously, the recessed region is formed in a shallow trench isolation (STI) pattern which typically defines active areas in silicon separated by isolation areas made of silicon oxide.

The recessed regions are defined such that the sidewalls are in silicon oxide, while the bottom is exposing the silicon (001) substrate. In this approach some of the recessed regions on the wafer (substrate) can be filled up with a III-V compound material according to the method of the invention, while other recessed regions on the same wafer can be filled up with crystalline germanium, thereby achieving active areas in two different materials and enabling in this way the heterogeneous integration of e.g. advanced CMOS devices.

In different embodiments of the present invention the group IV semiconductor material of the buffer layer can be germanium.

According to the method of the invention, both the group-IV semiconductor material of the buffer layer and the III-V compound semiconductor material can be grown epitaxially, in an e.g. LP CVD or MOVPE reactor or a MBE chamber.

The steps of epitaxially growing the buffer layer, applying a thermal treatment to form the double stepped surface and filling at least partially of the recessed region with a III-V compound semiconductor material can be performed either in separate chambers on different tools, or without vacuum break, in the same process chamber/reactor or in different chambers on the same cluster tool.

In embodiments of the invention wherein the buffer layer is made of germanium the thermal treatment can be performed in H2- and As-comprising atmosphere at a temperature above the roughening temperature between 600°C and 800°C. The thermal treatment can be performed in-situ in the MOVPE reactor prior to the III-V compound growth. Pre-treating the buffer layer in an atmosphere comprising As-precursor (such as TBAs, or arsine AsH3) forms a group V terminated surface beneficial for the III-V compound growth. Additional to the double step formation, the thermal treatment in H2/As-containing atmosphere removes any native germanium oxide present on the surface and forms a group V terminated surface which ready to be used for the epitaxial growth of the III-V compound materials.

In embodiments of the invention the III-V compound semiconductor grown in the recessed region can be any III-V compound such as III-arsenides, III-phosphides, III-nitrides, III-antimonides or combinations thereof.

Preferably the III-V compound semiconductor has a zincblende crystal structure. More preferably the III-V compound semiconductor is selected from the group consisting of AlAs, AlP, AlSb, BN, BP, GaAs, GaP, GaSb, InAs, InP, InSb or combinations thereof.

With the method described above, an engineered semiconductor substrate can be obtained comprising

a. a substrate made of a semiconductor material having a {001} orientation and thereupon a insulating layer overlying and in contact with the substrate and a recessed region in the insulating layer exposing at least partially the substrate,
b. a buffer layer overlying and in contact with the exposed substrate in the recessed region, comprising a group IV-semiconductor material and having a curved shape with a double stepped surface atop
c. a III-V compound semiconductor material layer filling at least partially the recessed region and overlying and in contact with the double stepped surface of the buffer layer.

In embodiments, both the exposed substrate in the recessed region and the curved buffer layer can have a concave shape. The substrate has locally, in the recessed region, a concave shape. As shown elsewhere in the description, the concave shape can be formed by isotropic etch of the exposed substrate in the recessed region. Thereupon, on the concave shaped substrate, a buffer layer is grown epitaxially, which will have at its turn also a concave shape. The local slope in the proximity of the trench center of the curved buffer layer should be high enough to achieve, after a thermal treatment, a double stepped surface with a (step density x step height) value of at least 0.05. For a given trench width, this can be controlled by adjusting the depth of the isotropic etch in the center if the trench and the thickness of the buffer layer. The local slope of the concave shaped substrate is preferably slightly higher than the local slope of the buffer layer.

In embodiments of the present invention a terrace width of the double stepped surface can be between 2 and 5nm..

In various embodiments, the recessed region has a width lower than 500 nm, more preferably lower than 200nm.

In the specific embodiment wherein the recessed region in Si (001) has a width of about 200nm and the buffer layer is made of germanium, the buffer layer thickness is between 10 and 50 nm.

According to some embodiments, the recessed region has a dual damascene profile as shown in Figure 4 (a).

First, a dual-damascene profile can be patterned starting from a shallow trench isolation initial pattern on a Si (100) wafer, using standard dual-damascene (via-first or trench first) processing technology. Secondly, as shown in Figure 4(b) a concave silicon recess is etched (e.g., chlorine- based reactive etchants with biasing control) at the bottom of the trench. Thereafter, the trench surface damage caused by the dry etch of the silicon substrate can be removed by removing a thin sacrificial oxide.

The dual damascene-STI patterned wafer is subsequently subjected to a selective epitaxial growth of a Ge buffer layer in the trench, prior to the growth of an III-V compound material (Figure 4(c)).

In a specific example, first a InP layer is grown on top of Ge buffer layer before a InGaAs layer is grown to complete the construction of defect free InGaAs channel on (001) silicon substrate.

An advantage of the dual damascene structure is that it enables the formation of the defect-free lateral growth zones. When combined with local creation of double stepped surfaces according to the method of the invention, the defect-free area of the III-V compound obtained is much higher including both the center and the lateral growth zones.

A specific embodiment discloses selective area growth of antiphase domain free InP layers in submicron trenches on exact (001) oriented Si substrates by using a thin Ge buffer layer.

The antiphase domain boundaries were successfully avoided by the controlled formation of double steps on the Ge buffer layer according to the method of the invention. The elimination of antiphase boundaries due to the double stepped Ge buffer layer combined with the defect necking effect yields a defect-free InP layer inside the trenches.

The Ge buffer layer is formed by selective area growth in submicron trenches on (001) exact oriented Si..

In this specific embodiment 200 mm Si (001) substrates are used. Trenches (recessed regions) with a 100nm and 200nm width and a trench length of 0.5 $\mu$m to 100 $\mu$m are defined with a conventional STI patterning scheme in Si-CMOS manufacturing. In this way, about 10% of the total Si wafer surface was exposed at the bottom of the trenches for the InP deposition.

The thickness of STI-insulation layer (SiO2) is about 300 nm. After a standard wet clean and an HF dip, the Si active areas in between two insulation areas were recessed to a depth of about 400 nm by HCl-vapor phase etching at 850 °C and 10Torr in an epitaxial reactor, preceded by an in-situ H2 bake at 850 °C for native oxide removal. Subsequently, a thin (about 30 nm) Ge layer was grown at 450 °C and atmospheric pressure, using GeH4 precursor (1% in H2 carrier gas).

After the thin Ge (buffer) layer deposition, the wafers were cleaved into 50×50 mm2 pieces and loaded into a metalorganic vapor phase epitaxy (MOVPE) reactor. Trimethylindum (TMIn) was used as group-III element precursor. For the group V element, tertiarybutylarsine (TBAs) and tertiarybutylphosphine (TBP) were used.

Before performing the epitaxial growth of InP, a thermal treatment (pre-epi bake) at 740 °C and reduced pressure in presence of TBAs and H2 carrier gas was carried out with a 3-fold objective: to remove the Ge native oxide, achieve the As-terminated surface and to promote double step formation.

Following this bake, the temperature was ramped down to 420 °C to grow about 30 nm InP seed layers. After the growth of the InP seed layer, the temperature was ramped to 640 °C for the bulk InP layer growth. The crystalline defects were characterized with transmission electron microscopy (TEM).

To create atomic steps, a thin Ge buffer layer was chosen since Ge double steps are more stable and can be formed at a much lower temperature compared to the temperature required for Si. The atomic step creation mechanism and the control parameters are schematically shown in Fig. 5.

A concave surface is obtained by over etch (isotropic) the Si substrate exposed at the bottom of the trenches. Si facets may form during the Si recess (Fig. 5b), but they are not required by the method of the invention. In micron wide trenches (right side of Fig. 5b), the (001) surface remains at the center of the trench, which impedes the formation of atomic steps.

In the next step, a thin Ge layer is grown on the faceted Si surface. The Ge epitaxial layer follows the starting Si surface but obscures the sharp intersection between two adjacent facets as a result of surface energy minimization. To create a double step surface on the Ge buffer layer, a high temperature treatment is used. At about 700 °C, above the Ge surface roughening temperature, the step formation energy approaches to zero, facilitating surface step formation.

As a result of the high temperature annealing applied, the Ge surface tends to evolve into a rounded surface comprising double steps. The step density on the rounded Ge surface can be approximated analytically by assuming a given surface profile. In a submicron trench, the surface profile can be considered as an elliptical surface described by the equation (1) below:

$$\frac{x^2}{\left(\dfrac{w}{2}\right)^2}+\frac{y^2}{h^2}=1 \qquad\qquad (1),$$

Where w is the trench width, h is the maximum distance from the Ge surface to the reference Si surface as shown in Fig. 5c. The surface step density can be obtained from the slope of the surface,

$$y'=\left|\frac{8hx}{w^2\sqrt{1-\left(\dfrac{2x}{w}\right)^2}}\right| \qquad\qquad (2)$$

Eq. (2) shows that the surface step density depends on the trench width, w, and the maximum distance between the Ge surface and the reference Si surface, h.

In general, the Ge surface step density at the edge of the trench is much larger than that at the trench center. According to the double step formation energetics on vicinal Ge (001) surfaces, to ensure Ge double step formation at the trench center, a minimum step density is required, which corresponds to minim value of the product (step density x step height) of 0.05 in the proximity of the trench center (x ≈5 nm). This value of the step density is equivalent to the step density on a 3° vicinal surface. For wider trenches a larger h is needed to create the same step density in the proximity of the trench center.

In general, the critical angle at which the transition between the single- and double-stepped surfaces occurs upon anneal is calculated to be about 2°. Experimental data place lower and upper bounds of 1° and, respectively, 3.5° degrees to the same angle. Throughout this application a step density equivalent with a local misalignment (critical angle) of 3° is considered as safe limit for achieving the growth of high quality (APBs free) III-V compound materials.

Figure 6 shows the cross-section TEM images of 100 nm and 200 nm wide trenches after InP growth. Si {111} and {311} facets are observed after the Si recess. The sharp edges of the recessed surface could have caused voids if InP was directly grown on the faceted Si surface. The thin Ge buffer layer mitigates the sharp edges and a relatively round surface is obtained. The step density in the proximity of the trench center is significantly larger than 0.05 in both trenches.

The rounded (curved) Ge surface of the Ge buffer layer has several advantages. First, the rounded surface creates initially a high density of single atomic steps. Upon annealing at a temperature above the Ge surface roughening temperature, single surface steps migrate and merge into double B steps. The formation of double B steps on the Ge buffer layer enables the growth of APB-free III-V compound material thereupon.

The rounded Ge surface obscure facets and the subsequent InP growth follows the Ge surface in a step flow growth mode instead of following different crystal orientation. As a result, no void formation occurs in the III-V compound layer.

Finally, the rounded Ge surface avoids the formation of crystal boundaries associated with the void formation when two crystal facets merge at the center of the trench. In addition, all the threading dislocations (TDs) are confined at the bottom of the trench. With the successful suppression of APB combined with the beneficial defect necking effect leads to defect-free InP layer at the top of the trenches.

TEM analysis along the 200 nm trench was performed to confirm the absence of APB in a larger area. Figure 7 shows the cross-section TEM image of the same trench as in Fig. 6b. No APBs are observed in this long trench. A flat and uniform InP layer grown on the double stepped Ge buffer layer along the complete length of the trench is obtained.

As shown in Eq. (2), if the local Ge thickness changes, the corresponding atomic step density will vary. The Ge layer grown selectively in the trenches has a uniform thickness which leads to a uniform Ge surface profile and surface atomic step density. The surface step density is determined by both the trench width and the maximum distance between the Ge surface and Si reference surface. The latter can be at its turn controlled by the etch depth in the middle of the trench and the buffer layer thickness. This provides a method to control the step density on the buffer layer and thereby the quality of the III-V compound material which is grown thereupon.

The resulting defect-free selective area grown InP layers enable the III-V channel device fabrication on standard Si (001) substrates. thereupon.

The rounded Ge surface obscure facets and the subsequent InP growth follows the Ge surface in a step flow growth mode instead of following different crystal orientation. As a result, no void formation occurs in the III-V compound layer.

Finally, the rounded Ge surface avoids the formation of crystal boundaries associated with the void formation when two crystal facets merge at the center of the trench. In addition, all the threading dislocations (TDs) are confined at the bottom of the trench. With the successful suppression of APB combined with the beneficial defect necking effect leads to defect-free InP layer at the top of the trenches.

TEM analysis along the 200 nm trench was performed to confirm the absence of APB in a larger area. Figure 7 shows the cross-section TEM image of the same trench as in Fig. 6b. No APBs are observed in this long trench. A flat and uniform InP layer grown on the double stepped Ge buffer layer along the complete length of the trench is obtained.

As shown in Eq. (2), if the local Ge thickness changes, the corresponding atomic step density will vary. The Ge layer grown selectively in the trenches has a uniform thickness which leads to a uniform Ge surface profile and surface atomic step density. The surface step density is determined by both the trench width and the maximum distance between the Ge surface and Si reference surface. The latter can be at its turn controlled by the etch depth in the middle of the trench and the buffer layer thickness. This provides a method to control the step density on the buffer layer and thereby the quality of the III-V compound material which is grown thereupon.

The resulting defect-free selective area grown InP layers enable the III-V channel device fabrication on standard Si (001) substrates.

## Claims

1. A method for manufacturing a III-V compound semiconductor material comprising the steps of:

   a. providing a substrate made of a first semiconductor material having an exact {001} orientation, an insulating layer overlying and in contact with the substrate and a recessed region in the insulating layer which exposes at least partially the substrate, the recessed region having a predetermined width at the exposed substrate;
   b. forming a buffer layer overlying and in contact with the exposed substrate in the recessed region, wherein the buffer layer has a predetermined thickness and comprises a group IV semiconductor material;
   c. applying a thermal treatment at a predetermined temperature higher or equal to the temperature at which the free energy of step formation becomes zero and double step formation is promoted for the group IV semiconductor material from which the buffer layer is made,

   wherein the method comprises, prior to step b of forming the buffer layer, performing an isotropic wet etch of the exposed substrate in the recessed region, such that the exposed substrate takes a concave shape and the buffer layer formed thereon also takes a concave shape;
   wherein the predetermined width of the recessed region, the predetermined thickness of the buffer layer and the predetermined temperature are chosen such that the buffer layer, after application of the thermal treatment, takes a concave shape with a curved surface of which the terrace width is smaller or equal to 5 nm and that double steps are formed over the whole curved surface,
   the method further comprising the step of

   d. filling at least partially the recessed region with an III-V compound semiconductor material which is overlying and in contact with the double stepped curved surface of the buffer layer.

2. The method according to claim 1, wherein step b of forming the buffer layer comprises growing epitaxially the buffer layer comprising the group IV semiconductor material on the exposed substrate.

3. The method according to any one of the preceding claims, wherein a width of the recessed region is smaller than 500nm, preferably smaller than 200nm.

4. The method according to any one of the preceding claims, wherein an additional thermal treatment is performed after the isotropic etch and prior to growing the buffer layer.

5. The method according to any one of the preceding claims, wherein the recessed region has a dual damascene profile.

6. The method according to any one of the preceding claims, wherein the first semiconductor material is silicon and the insulating layer is silicon oxide, wherein a plurality of recessed regions are provided in the insulating layer, and wherein some of the recessed regions are filled up with the III-V compound material and other of the recessed regions are filled up with crystalline germanium.

7. The method according to any one of the preceding claims, wherein the recessed region is formed with a shallow trench isolation (STI) pattern.

8. The method according to any one of the preceding claims, wherein the group IV semiconductor material is germanium and the thermal treatment is performed in H2 and As comprising atmosphere at a temperature between 600°C and 800°C.

9. The method according to any one of the preceding claims, wherein the III-V compound semiconductor has a zincblende crystal structure.

10. An engineered semiconductor substrate comprising

   a. a substrate made of a first semiconductor material having an exact {001} orientation, an insulating layer overlying and in contact with the substrate and a recessed region in the insulating layer which exposes at least partially the substrate, the recessed region having a predetermined width at the exposed substrate;
   b. a buffer layer overlying and in contact with the exposed substrate in the recessed region, wherein the buffer layer has a predetermined thickness and comprises a group IV-semiconductor material and having a rounded shape with a curved surface with double steps over the whole curved surface and a terrace width which is smaller or equal to 5 nm;
   c. a III-V compound semiconductor material layer filling at least partially the recessed region and overlying and in contact with the double stepped curved surface of the buffer layer;

   wherein both the exposed substrate and the rounded buffer layer have a concave shape.

11. The engineered substrate according to claim 10, wherein the terrace width of the double stepped curved surface is between 2 and 5 nm.

12. The engineered substrate according to any one of the claims 10-11, wherein the predetermined width of the recessed region is smaller or equal to 500 nm, preferably smaller than 200 nm.

13. The engineered substrate according to any one of the claims 10-12, wherein the substrate is made of silicon and the insulating layer is made of silicon oxide, wherein a plurality of recessed regions are provided in the insulating layer, and wherein some of the recessed regions are filled up with the III-V compound material and other of the recessed regions are filled up with crystalline germanium.

14. The engineered substrate according to any one of the claims 10-13, wherein the group IV-semiconductor material is germanium.

15. The engineered substrate according to any one of the claims 10-14, wherein the recessed region has a dual damascene profile.

16. The engineered substrate according to any one of the claims 10-15, wherein the III-V compound semiconductor has a zincblende crystal structure.

17. The engineered substrate according to any one of the claims 10-16, wherein the III-V compound semiconductor comprises InP and InGaAs.


**Patentansprüche**

1. Ein Verfahren zur Herstellung eines III-V-Verbindungshalbleitermaterials, welches die folgenden Schritte umfasst:

   a. Bereitstellung eines Substrats hergestellt aus einem ersten Halbleitermaterial mit einer exakten {001} Orientierung, einer Isolationsschicht, welche das Substrat überlagert und mit diesem in Kontakt ist, und einer ausgesparten Region in der Isolationsschicht, welche das Substrat zumindest teilweise exponiert, wobei die ausgesparte Region eine vorbestimmte Breite am exponierten Substrat aufweist;
   b. Bildung einer Pufferschicht, welche das exponierte Substrat in der ausgesparten Region überlagert und mit diesem in Kontakt ist, wobei die Pufferschicht eine vorbestimmte Dicke hat und ein Gruppe-IV-Halbleitermaterial umfasst;

c. Anwendung einer thermischen Behandlung bei einer vorbestimmten Temperatur, höher oder gleich der Temperatur, bei der die freie Energie der Stufenbildung null wird und doppelte Stufenbildung für das Gruppe-IV-Halbleitermaterial, aus dem die Pufferschicht hergestellt ist, gefördert wird,

wobei das Verfahren, vor Schritt b der Bildung der Pufferschicht, die Ausführung einer isotropen Nassätzung des exponierten Substrats in der ausgesparten Region umfasst, sodass das exponierte Substrat eine konkave Form annimmt und die darauf geformte Pufferschicht auch eine konkave Form annimmt;

wobei die vorbestimmte Breite der ausgesparten Region, die vorbestimmte Dicke der Pufferschicht und die vorbestimmte Temperatur so gewählt sind, dass die Pufferschicht, nach Anwendung der thermischen Behandlung, eine konkave Form mit einer gebogenen Oberfläche annimmt, deren Terrassenbreite kleiner als oder gleich 5 nm ist, und dass Doppelstufen über die gesamte gebogene Oberfläche geformt werden,

wobei das Verfahren ferner den folgenden Schritt umfasst:

d. zumindest teilweises Füllen der ausgesparten Region mit einem III-V-Verbindungshalbleitermaterial, welches die doppelt gestufte gebogene Oberfläche der Pufferschicht überlagert und mit dieser in Kontakt ist.

2. Das Verfahren nach Anspruch 1, wobei Schritt b der Bildung der Pufferschicht das epitaktische Aufwachsen der Pufferschicht umfasst, welche das Gruppe-IV-Halbleitermaterial auf dem exponierten Substrat umfasst.

3. Das Verfahren nach irgendeinem der vorigen Ansprüche, wobei eine Breite der ausgesparten Region kleiner als 500 nm ist, bevorzugt kleiner als 200 nm.

4. Das Verfahren nach irgendeinem der vorigen Ansprüche, wobei nach der isotropen Ätzung und vor dem Anwachsen der Pufferschicht eine zusätzliche thermische Behandlung ausgeführt wird.

5. Das Verfahren nach irgendeinem der vorigen Ansprüche, wobei die ausgesparte Region ein duales Damascene-Profil hat.

6. Das Verfahren nach irgendeinem der vorigen Ansprüche, wobei das erste Halbleitermaterial Silicium ist und die Isolationsschicht Siliciumoxid ist, wobei eine Vielzahl ausgesparter Regionen in der Isolationsschicht bereitgestellt sind, und wobei einige der ausgesparten Regionen mit dem III-V-Verbindungsmaterial gefüllt sind und andere der ausgesparten Regionen mit kristallinem Germanium gefüllt sind.

7. Das Verfahren nach irgendeinem der vorigen Ansprüche, wobei die ausgesparte Region mit einem flachen Grabenisolation (STI) Muster geformt ist.

8. Das Verfahren nach irgendeinem der vorigen Ansprüche, wobei das Gruppe-IV-Halbleitermaterial Germanium ist und die thermische Behandlung in einer $H_2$ und As umfassenden Atmosphäre bei einer Temperatur zwischen 600 °C und 800 °C ausgeführt wird.

9. Das Verfahren nach irgendeinem der vorigen Ansprüche, wobei der III-V-Verbindungshalbleiter eine Zinkblende-Kristallstruktur hat.

10. Ein angefertigtes Halbleitersubstrat, welches Folgendes umfasst:

a. ein Substrat hergestellt aus einem ersten Halbleitermaterial mit einer exakten {001} Orientierung, eine Isolationsschicht, welche das Substrat überlagert und mit diesem in Kontakt ist, und eine ausgesparte Region in der Isolationsschicht, welche das Substrat zumindest teilweise exponiert, wobei die ausgesparte Region eine vorbestimmte Breite am exponierten Substrat aufweist;

b. eine Pufferschicht, welche das exponierte Substrat in der ausgesparten Region überlagert und mit diesem in Kontakt ist, wobei die Pufferschicht eine vorbestimmte Dicke hat und ein Gruppe-IV-Halbleitermaterial umfasst und eine gerundete Form mit einer gebogenen Oberfläche mit Doppelstufen über die gesamte gebogene Oberfläche aufweist und eine Terrassenbreite, die kleiner als oder gleich 5 nm ist;

c. eine III-V-Verbindungshalbleitermaterialschicht, welche die ausgesparte Region zumindest teilweise füllt, und die doppelt gestufte gebogene Oberfläche der Pufferschicht überlagert und mit dieser in Kontakt ist;

wobei sowohl das exponierte Substrat als auch die gerundete Pufferschicht eine konkave Form haben.

**11.** Das angefertigte Substrat nach Anspruch 10, wobei die Terrassenbreite der doppelt gestuften gebogenen Oberfläche zwischen 2 und 5 nm beträgt.

**12.** Das angefertigte Substrat nach irgendeinem der Ansprüche 10-11, wobei die vorbestimmte Breite der ausgesparten Region kleiner als oder gleich 500 nm ist, bevorzugt kleiner als 200 nm.

**13.** Das angefertigte Substrat nach irgendeinem der Ansprüche 10-12, wobei das Substrat aus Silicium hergestellt ist und die Isolationsschicht aus Siliciumoxid hergestellt ist, wobei eine Vielzahl ausgesparter Regionen in der Isolationsschicht bereitgestellt sind, und wobei einige der ausgesparten Regionen mit dem III-V-Verbindungsmaterial gefüllt sind und andere der ausgesparten Regionen mit kristallinem Germanium gefüllt sind.

**14.** Das angefertigte Substrat nach irgendeinem der Ansprüche 10-13, wobei das Gruppe-IV-Halbleitermaterial Germanium ist.

**15.** Das angefertigte Substrat nach irgendeinem der Ansprüche 10-14, wobei die ausgesparte Region ein duales Damascene-Profil hat.

**16.** Das angefertigte Substrat nach irgendeinem der Ansprüche 10-15, wobei der III-V-Verbindungshalbleiter eine Zinkblende-Kristallstruktur hat.

**17.** Das angefertigte Substrat nach irgendeinem der Ansprüche 10-16, wobei der III-V-Verbindungshalbleiter InP und InGaAs umfasst.

## Revendications

**1.** Procédé de fabrication d'un matériau semi-conducteur composite III-V, comprenant les étapes consistant à :

a. fournir un substrat constitué d'un premier matériau semi-conducteur ayant une orientation exacte {001}, une couche isolante recouvrant et en contact avec le substrat et une région évidée dans la couche isolante qui expose au moins en partie le substrat, la partie évidée ayant une largeur prédéterminée sur le substrat exposé ;
b. former une couche tampon recouvrant et en contact avec le substrat exposé dans la région évidée, dans lequel la couche tampon a une épaisseur prédéterminée et comprend un matériau semi-conducteur du groupe IV ;
c. appliquer un traitement thermique à une température prédéterminée supérieure ou égale à la température à laquelle l'énergie libre de formation de gradins devient nulle et la formation de doubles gradins est favorisée pour le matériau semi-conducteur du groupe IV dont la couche tampon est constituée,

dans lequel le procédé comprend, avant l'étape b de formation de la couche tampon, la réalisation d'une gravure isotrope humide du substrat exposé dans la région évidée de sorte que le substrat exposé adopte une forme concave et que la couche tampon qui y est formée adopte également une forme concave;
dans lequel la largeur prédéterminée de la région évidée, l'épaisseur prédéterminée de la couche tampon et la température prédéterminée sont choisies de sorte que la couche tampon, après application du traitement thermique, adopte une forme concave avec une surface incurvée dont la terrasse a une largeur inférieure ou égale à 5 mm et que des doubles gradins soient formés sur toute la surface incurvée,
le procédé comprenant en outre l'étape suivante :

d. le remplissage au moins en partie de la région évidée par un matériau semi-conducteur composite III-V qui recouvre et est en contact avec la surface incurvée à double gradins de la couche tampon.

**2.** Procédé selon la revendication 1, dans lequel l'étape b de formation de la couche tampon comprend la croissance épitaxiale de la couche tampon comprenant le matériau semi-conducteur du groupe IV sur le substrat exposé.

**3.** Procédé selon l'une quelconque des revendications précédentes, dans lequel la largeur de la région évidée est inférieure à 500 nm, de préférence inférieure à 200 nm.

**4.** Procédé selon l'une quelconque des revendications précédentes, dans lequel un traitement thermique supplémentaire est effectué après la gravure isotrope et avant la croissance de la couche tampon.

5. Procédé selon l'une quelconque des revendications précédentes, dans lequel la région évidée a un profil damascène double.

6. Procédé selon l'une quelconque des revendications précédentes, dans lequel le premier matériau semi-conducteur est le silicium et la couche isolante est l'oxyde de silicium, dans lequel une pluralité de régions évidées sont ménagées dans la région isolante et dans lequel certaines des régions évidées sont remplies du matériau composite III-V et d'autres des régions évidées sont remplies de germanium cristallin.

7. Procédé selon l'une quelconque des revendications précédentes, dans lequel la région évidée est formée avec un motif isolant de tranchées peu profondes (STI).

8. Procédé selon l'une quelconque des revendications précédentes, dans lequel le matériau semi-conducteur du groupe IV est le germanium et le traitement thermique est effectué dans une atmosphère comprenant $H_2$ et As à une température comprise entre 600°C et 800°C.

9. Procédé selon l'une quelconque des revendications précédentes, dans lequel le semi-conducteur composite III-V a une structure cristalline de blende de zinc.

10. Substrat semi-conducteur élaboré comprenant :

a. un substrat constitué d'un premier matériau semi-conducteur ayant une orientation exacte {001}, une couche isolante recouvrant et en contact avec le substrat et une région évidée dans la couche isolante qui expose au moins en partie le substrat, la région évidée ayant une largeur prédéterminée sur le substrat exposé ;
b. une couche tampon recouvrant et en contact avec le substrat exposé dans la région évidée, dans lequel la couche tampon a une épaisseur prédéterminée et comprend un matériau semi-conducteur du groupe IV et ayant une forme arrondie avec une surface incurvée présentant des doubles gradins sur toute la surface incurvée et une largeur de terrasse qui est inférieure ou égale à 5 nm ;
c. une couche de matériau semi-conducteur composite III-V remplissant au moins en partie la région évidée et recouvrant et en contact avec la surface incurvée à double gradins de la couche tampon ;

dans lequel à la fois le substrat exposé et la couche tampon arrondie ont une forme concave.

11. Substrat élaboré selon la revendication 10, dans lequel la largeur de la terrasse de la surface incurvée à double gradins se situe entre 2 et 5 nm.

12. Substrat élaboré selon l'une quelconque des revendications 10-11, dans lequel la largeur prédéterminée de la région évidée est inférieure ou égale à 500 nm, de préférence inférieure à 200 nm.

13. Substrat élaboré selon l'une quelconque des revendications 10-12, dans lequel le substrat est constitué de silicium et la couche isolante est constituée d'oxyde de silicium, dans lequel une pluralité de régions évidées sont ménagées dans la couche isolante et dans lequel certaines des régions évidées sont remplies du matériau composite III-V et d'autres des régions évidées sont remplies de germanium cristallin.

14. Substrat élaboré selon l'une quelconque des revendications 10-13, dans lequel le matériau semi-conducteur du groupe IV est le germanium.

15. Substrat élaboré selon l'une quelconque des revendications 10-14, dans lequel la région évidée a un profil damascène double.

16. Substrat élaboré selon l'une quelconque des revendications 10-15, dans lequel le semi-conducteur composite III-V a une structure cristalline de blende de zinc.

17. Substrat élaboré selon l'une quelconque des revendications 10-16, dans lequel le semi-conducteur composite III-V comprend du InP et du InGaAs.

**Fig. 1**

Fig. 2

**Fig. 3**

(a)

(b)

(c)

**Fig. 4**

**Fig. 5**

**Fig. 6**

**Fig. 7**